# EUROPÄISCHE PATENTSCHRIFT

(11) **EP 2 654 391 B1**
(45) Veröffentlichungstag und Bekanntmachung des Hinweises auf die Patenterteilung: **28.11.2018**
(21) Anmeldenummer: 13154128.6
(22) Anmeldetag: 06.02.2013
(51) Int. Cl.: H05K 7/20, H01L 25/07, H01L 25/11, H01L 23/473

(54) **Flüssigkeitsgekühlte Anordnung mit anreihbaren Leistungshalbleitermodulen und mindestens einer Kondensatoreinrichtung und Leistungshalbleitermodul hierzu**
Liquid-cooled assembly with in-line power semiconductor modules and at least one capacitor device and power semiconductor module therefor
Agencement refroidi par liquide avec modules semi-conducteurs de puissance pouvant être joints et au moins un dispositif de condensateur et module semi-conducteur de puissance à cet effet

(30) Priorität: 17.04.2012 DE 102012206271
(43) Veröffentlichungstag der Anmeldung: 23.10.2013
(73) Patentinhaber: SEMIKRON Elektronik GmbH & Co. KG, 90431 Nürnberg (DE)
(72) Erfinder: Knebel, Markus, 90587 Tuchenbach (DE); Kalla, Susanne, 92263 Ebermannsdorf (DE); Maul, Andreas, 90461 Nürnberg (DE); Steger, Jürgen, 91355 Hiltpoltstein (DE)

(56) Entgegenhaltungen:
- EP-A2- 1 959 719
- EP-B1- 1 815 514
- WO-A1-2013/094028
- DE-A1- 10 100 620
- US-A1- 2006 096 299
- US-A1- 2010 302 733
- US-A1- 2011 194 246

## Beschreibung

Die Erfindung beschreibt eine Anordnung mit anreihbaren Leistungshalbleitermodulen und mindestens einer Kondensatoreinrichtung insbesondere geeignet für den Einsatz in dezentralen Energieversorgungseinrichtungen. Hierfür ist die Anordnung mit einer Flüssigkeitskühleinrichtung vorgesehen und derart ausgebildet, dass sie beispielhaft als Wechselrichterschaltung in Windkraftanlagen einsetzbar ist.

Grundsätzlich sind anreihbare Leistungshalbleitermodule und Anordnungen hieraus beispielhaft aus der DE 103 16 356 A1 bekannt. Die dort Teilmodule genannten Leistungshalbleitermodule weisen ein Gehäuse, sowie Last- und Hilfsanschlusseinrichtung auf. Die Leistungshalbleitermodule sind nebeneinander auf einer Kühleinrichtung anordenbar und mittels Verbindungseinrichtung zu einer Gesamtanordnung verbunden.

Weiterhin sind aus der EP 1 815 514 B1 Durchflussverteilungsmodule und eine Anordnung hieraus bekannt. Hierbei weist das Durchflussverteilermodul als Teil eines Kühlsystems ein Gehäuse, einen Einlassverteiler, einen Auslassverteiler und eine Vielzahl von Durchflusszellen auf. Diese Zellen können als offene Zellen ausgebildet sein, wobei in die Öffnung eine leistungselektronische Schalteinrichtung eingesetzt werden kann. Hierbei entsteht eine abzudichtende Fläche zwischen dem Durchflussverteilermodul und der leistungselektronischen Schalteinrichtung.

In Kenntnis dieses Standes der Technik liegt der Erfindung die Aufgabe zugrunde, derartige Anordnungen weiterzubilden, dass sie in Kombination mit einer Flüssigkeitskühlung besonders kompakt aufgebaut sind und gleichzeitig einer flexiblen und besonders geeigneten externen Verbindung zugänglich ist. Ebenso ist es Aufgabe der Erfindung ein besonders vorteilhaftes Leistungshalbleitermodul für eine derartige Anordnung vorzustellen.

Aus der US 2010/302733 A1 ist eine gestapelte Busschienen-Anordnung bekannt. Diese umfasst zwei oder mehr Busschienen-Unteranordnungen, wobei jede eine Mehrzahl von Busschienen mit einer oder mehreren daran befestigten Leistungs-Halbleitervorrichtungen (zum Beispiel IGBTs, Leistungsdioden und dergleichen) umfasst. Jede Busschiene weist ein internes integriertes Kühlungssystem einschließlich einem oder mehreren Fluidkanälen in Verbindung mit einem Einlass und einem Auslass auf. Die Busschienenanordnungen sind derart gestapelt, dass ihre entsprechenden Einlässe und Auslässe ausgerichtet sind und Kühlmittel somit parallel dort hindurch fließen kann.

Die WO 2013/09428 A1 offenbart ein verbessertes Halbleitermodul mit eingebautem Kühler. Ein Halbleitermodul ist mit mehreren flachbaugruppenartigen Kühlplatten, mehreren flachbaugruppenartigen Halbleitereinrichtungen und mehreren flachbaugruppenartigen Ansteuereinrichtungen. Jede der Halbleitereinrichtungen weist ein darin untergebrachtes Leistungshalbleiterbauelement auf. Jede der Ansteuereinrichtungen weist darin eine elektronische Komponente auf, die sich von der der Halbleitereinrichtungen unterscheidet. Die Kühlplatten und die Halbleitereinrichtungen bzw. die Ansteuereinrichtungen sind abwechselnd laminiert. Verbindungsrohre sind zwischen den nebeneinander liegenden Kühlplatten vorgesehen, wobei die Verbindungsrohre ein darin fließendes Kühlmedium aufweisen.

Diese Aufgabe wird erfindungsgemäß gelöst durch eine Anordnung mit den Merkmalen des Anspruchs 1. Bevorzugte Ausführungsformen sind in den abhängigen Ansprüchen beschrieben.

Die erfindungsgemäße Anordnung weist einen Kühlkreislauf, einer Mehrzahl von anreihbaren Leistungshalbleitermodulen und mindestens eine Kondensatoreinrichtung auf. Hierbei weist das jeweilige Leistungshalbleitermodul eine quaderförmige Grundform auf, wodurch zwei Haupt-, zwei Längs- und zwei Schmalseiten, die sich jeweils paarweise gegenüberliegen, definiert werden. Die Hauptseiten sind weiterhin dadurch definiert, dass bezogen auf die quaderförmige Grundform ihr Flächeninhalt der größte ist, während entsprechend derjenige Flächeninhalt der Schmalseiten der kleinste ist. Diese jeweiligen Seiten bilden unter Beibehaltung der quaderförmigen Grundform nicht zwangsläufig vollständig ebenen Flächen aus, vielmehr können die Flächen der jeweiligen Seiten Einzüge und alternativ oder zusätzlich Ausnehmungen, beispielhaft für Anschlusselemente aufweisen.

Weiterhin weist jedes Leistungshalbleitermodul eine leistungselektronische Schalteinrichtung und eine durchströmbare Kühleinrichtung hierfür auf. Hierbei weist die Kühleinrichtung vier Anschlusseinrichtungen für die Kühlflüssigkeit und ein Kühlvolumen mit mindestens einer Kühlfläche auf. Unter Kühlvolumen soll hierbei insbesondere eine einzelne durchströmbare Kammer oder eine Mehrzahl parallel oder seriell durchströmbarer Kammern verstanden werden. Diese Kammern bilden Hohlräume der Kühleinrichtung aus, wobei an mindestens einem dieser Hohlräume mindestens eine Kühlfläche angrenzt. Die mindestens eine Kühlfläche ist vorzugsweise parallel zu den Hauptseiten angeordnet.

Die vier Anschlusseinrichtungen der Kühleinrichtung für die Kühlflüssigkeit sind paarweise an den Hauptseiten des Leistungshalbleitermoduls angeordnet. Die Anschlusseinrichtungen für die Kühlflüssigkeit sind ausgebildet als jeweils ein Vorlaufzu- und ein Vorlaufabfluss sowie als ein Rücklaufzu- und ein Rücklaufabfluss. Unter Vorlauf wird hierbei insbesondere derjenige Flüssigkeitsstrom verstanden, der die Kühlflüssigkeit zu einem zu kühlenden Gegenstand transportiert, während der Rücklauf insbesondere derjenige Flüssigkeitsstrom ist, der nach dem Wärmeübergang vom zu kühlenden Gegenstand die Kühlflüssigkeit wegtransportiert.

Das Leistungshalbleitermodul weist bevorzugt eine leistungselektronische Schalteinrichtung mit einer leistungselektronischen Schaltung, Steuer-, Lasteingangs- und Lastausgangsanschlusseinrichtungen auf. Weiterhin ist es bevorzugt, wenn das Leistungshalbleitermodul ein Gehäuse mit Ausnehmungen für diese Anschlusseinrichtungen aufweist, und hierbei das Gehäuse die leistungselektronische Schaltung zur Kühleinrichtung hin überdeckt.

Die die Anordnung bildenden Leistungshalbleitermodule sind mit ihren Hauptseiten aneinandergereiht, indem korrespondierende Anschlusseinrichtungen aufeinanderfolgender Leistungshalbleitermodule mittelbar oder unmittelbar miteinander verbunden sind. Weiterhin ist zwischen mindestens zwei aufeinanderfolgenden Leistungshalbleitermodulen eine Kondensatoreinrichtung angeordnet, die ihrerseits mittels des Kühlkreislaufes der Anordnung direkt oder indirekt gekühlt wird.

Unter einer direkten Kühlung soll verstanden werden, dass die Kondensatoreinrichtung eine eigene Anbindung an den Kühlkreislauf aufweist, während eine indirekte Kühlung diese Anbindung nicht aufweist.

Es ist bei indirekter Kühlung grundsätzlich bevorzugt, wenn die Kondensatoreinrichtung in thermisch leitendem Kontakt mit einer Kühlfläche eines oder beider benachbarter Leistungshalbleitermodule steht und die korrespondierenden Anschlusseinrichtungen für Kühlflüssigkeit benachbarter Leistungshalbleitermodule unmittelbar miteinander verbunden sind.

Es ist bei direkter Kühlung bevorzugt, wenn die Kondensatoreinrichtung in thermisch leitendem Kontakt mit einer Kühlfläche eines benachbarten Leistungshalbleitermoduls steht und die korrespondierenden Anschlusseinrichtungen für Kühlflüssigkeit benachbarter Leistungshalbleitermodul mittelbar miteinander verbunden sind.

Unter einer unmittelbaren Verbindung ist hierbei eine Verbindung zu verstehen bei der die korrespondierenden Anschlusseinrichtungen direkt unter ausschließlicher Ergänzung durch notwendige Dichtmittel verbunden sind. Unter einer mittelbaren Verbindung ist hierbei eine Verbindung zu verstehen, bei der die korrespondierenden Anschlusseinrichtungen nicht direkt miteinander verbunden sind. Dies ist beispielhaft der Fall, wenn die Kondensatoreinrichtung eigenständig ist und eigene zweite Anschlusseinrichtungen aufweist, die jeweils als ein Vorlaufzu- und ein Vorlaufabfluss sowie als eine Rücklaufzu- und ein Rücklaufabfluss ausgebildet sind. Dadurch können die korrespondierenden Anschlusseinrichtungen benachbarter Leistungshalbleitermodule mittelbar miteinander verbunden sein, indem die Kondensatoreinrichtung in Bezug auf den Kühlkreislauf dazwischengeschaltet ist.

In diesem Fall ist es besonders vorteilhaft, wenn die Kondensatoreinrichtung durchströmbar für die Kühlflüssigkeit ausgebildet ist und hierzu ein zweites Kühlvolumen sowie zu dessen Durchströmung zweite dem Vor- bzw. Rücklauf zugeordnete Abzweige aufweist.

Vorzugsweise weist diese Kondensatoreinrichtung Lastanschlusseinrichtungen auf, wobei diese schaltungsgerecht mit zugeordneten Lasteingangs- oder Lastausgangsanschlusseinrichtungen mindestens eines Leistungshalbleitermoduls verbunden sind. Falls die Anordnung zur Ausbildung einer Wechselrichterschaltung dient, sind, bezogen auf die Schaltung als solche in fachüblicher Weise, die Lasteingangsanschlusseinrichtungen des Leistungshalbleitermoduls mit den Lastanschlusseinrichtungen der Kondensatoreinrichtung verbunden, die damit einen Glättungskondensator sowie gleichzeitig oder alternativ einen Zwischenkreiskondensator ausbildet. Falls die Anordnung zur Ausbildung einer Gleichrichterschaltung dient, sind, bezogen auf die Schaltung als solche in fachüblicher Weise, die Lastausgangsanschlusseinrichtungen des Leistungshalbleitermoduls mit den Lastanschlusseinrichtungen der Kondensatoreinrichtung verbunden.

Für derartige Anordnungen ist das integrierte Leistungshalbleitermodul besonders vorteilhaft, da dieses die Kondensatoreinrichtung in einem gemeinsamen Gehäuse mit dem Leistungshalbleiterteilmodul, das im Wesentlichen den oben genannten Leistungshalbleitermodulen entspricht, aufweist. Dieses integrierte Leistungshalbleitermodul weist ebenso eine leistungselektronische Schalteinrichtung und eine durchströmbare Kühleinrichtung hierfür auf, wobei diese ein Kühlvolumen mit mindestens einer Kühlfläche, zur Kühlung der leistungselektronischen Schaltung und der Kondensatoreinrichtung aufweist. Ebenso weist das integrierte Leistungshalbleitermodul vier Anschlusseinrichtungen für die Kühlflüssigkeit auf, die paarweise an Hauptseiten des integrierten Leistungshalbleitermoduls angeordnet sind. Die integrierten Leistungshalbleitermodule sind mit ihren Hauptseiten unmittelbar anreihbar indem korrespondierende Anschlusseinrichtungen aufeinanderfolgender Leistungshalbleitermodule unmittelbar, unter Verwendung notwendiger Dichteinrichtungen, miteinander verbindbar sind.

In einer besonders vorteilhaften Ausgestaltung ist das integrierte Leistungshalbleitermodul gemeinsam mit seiner Kondensatoreinrichtung staub- und feuchtigkeitsdicht verkapselt.

Weitere Erläuterung der Erfindung vorteilhafte Einzelheiten und Merkmale ergeben sich aus der nachfolgenden Beschreibung der in den Fig. 1 bis 6 dargestellten Ausführungsbeispiele der erfindungsgemäßen Anordnung oder des Leistungshalbleitermoduls hierfür.
Figur 1 zeigt in dreidimensionaler Ansicht ein Leistungshalbleitermodul einer erfindungsgemäßen Anordnung.
Figur 2 zeigt schematisch eine Draufsicht aus Richtung einer Längsseite auf einen Schnitt durch ein Leistungshalbleitermodul einer erfindungsgemäßen Anordnung.
Figur 3 zeigt eine Draufsicht aus Richtung einer Hauptseite auf ein Leistungshalbleitermodul ohne Gehäuse bzw. auf eine entsprechende Kondensatoreinrichtung.
Figur 4 zeigt im oberen Teil eine schematische Draufsicht aus Richtung einer Längsseite auf einen Schnitt durch ein Leistungshalbleiterteilmodul und im unteren Teil eine entsprechend Draufsicht auf eine Kondensatoreinrichtung.
Figur 5 zeigt eine dreidimensionale Ansicht einer ersten Ausgestaltung einer Anordnung zur Erläuterung der Erfindung.
Figur 6 zeigt eine dreidimensionale Ansicht einer zweiten, erfindungsgemäßen Ausgestaltung der Anordnung.

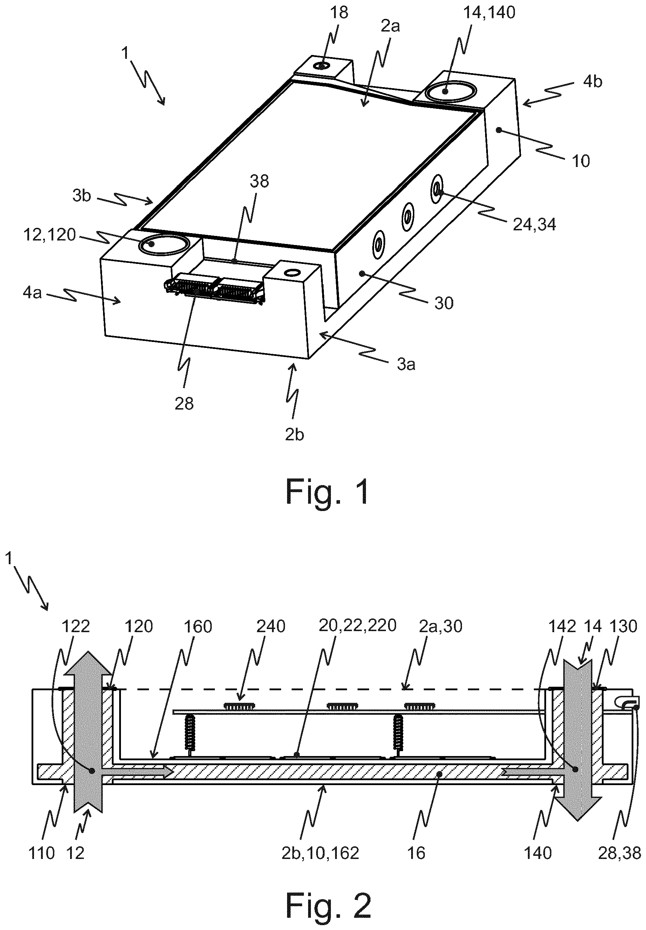

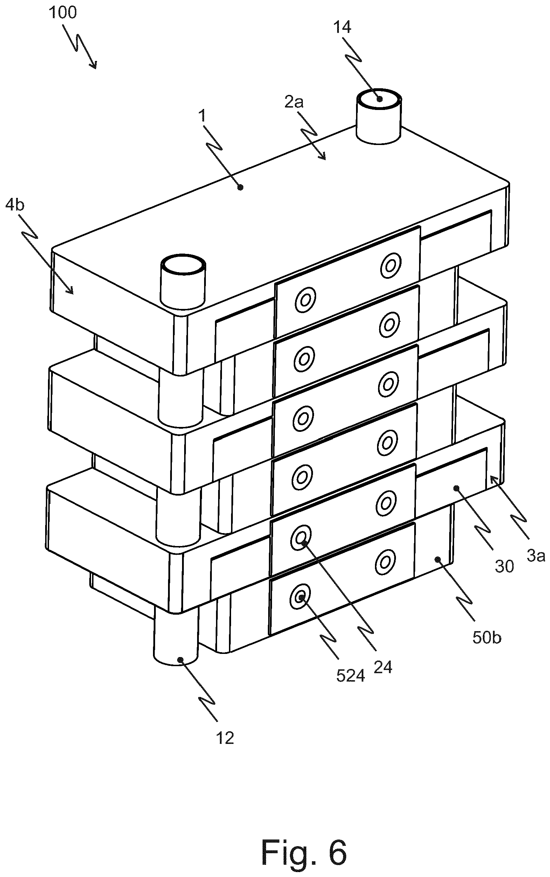

Figur 1 zeigt in dreidimensionaler Ansicht ein Leistungshalbleitermodul 1 einer erfindungsgemäßen Anordnung 100 (vgl. Fig. 6), bei der die quaderförmige Grundform des Leistungshalbleitermoduls 1 deutlich erkennbar ist. Das Leistungshalbleitermodul 1 weist somit zwei Hauptseiten 2 a/b auf, auf denen jeweils eng benachbart zu den Längs- 3 a/b und Schmalseiten 4 a/b in gegenüberliegenden Ecken die Anschlusseinrichtungen 110, 120, 130, 140 für die Kühlflüssigkeit angeordnet sind. Diese Anschlusseinrichtungen 110, 120, 130, 140 sind Teil der Kühleinrichtung 10 des Leistungshalbleitermoduls 1. Auf der ersten Hauptseite 2a sind hier ein Vorlaufabfluss 120 und ein Rücklaufabfluss 140 dargestellt. In den beiden verbleibenden Ecken sind die Kühleinrichtung 10 zwischen den Hauptflächen 2 a/b durchdringende Ausnehmungen 18 vorgesehen, die bei der Aneinanderreihung einer Mehrzahl von Leistungshalbleitermodulen 1 zu deren Verbindung dienen.

Ebenfalls dargestellt ist ein Gehäuse 30 des Leistungshalbleitermoduls 1, das die Ausnehmung der U-förmig ausgebildeten Kühleinrichtung 10 überdeckt und dabei wesentliche Teile der ersten Hauptseite 2a ausbildet. Durch das Gehäuse 30 überdeckt und nicht sichtbar ist die leistungselektronische Schaltung 22 der leistungselektronischen Schalteinrichtung 20 des Leistungshalbleitermoduls 1 angeordnet. Von der leistungselektronischen Schalteinrichtung 20 sichtbar sind Lastanschlusseinrichtungen 24, 26, hier Lastausgangsanschlusseinrichtungen 26, sowie Steueranschlusseinrichtungen 28. Diese durchdringen das Gehäuse 30 an jeweils zugeordneten Ausnehmungen 34, 36, 38, die Lastanschlusseinrichtungen 24, 26 an Längs- 3a /b, die Steueranschlusseinrichtungen 28 an einer Schmalseite 4a des Leistungshalbleitermoduls 1.

Figur 2 zeigt schematisch eine Draufsicht aus Richtung einer Längsseite 3a auf einen Schnitt durch ein Leistungshalbleitermodul 1 einer erfindungsgemäßen Anordnung 100. Dargestellt ist wiederum eine U-förmige Kühleinrichtung 10, die eine zweite Hauptseite 2b sowie die beiden Schmalseiten 4 a/b des Leistungshalbleitermoduls 1 annährend vollständig ausbildet. Ebenso bildet die Kühleinrichtung 10 einen Teil der ersten Hauptseite 2a, wie auch Teile der beiden Längsseiten 3 a/b aus (vgl. Fig. 1). Die übrigen Teile der ersten Hauptseite 2a, wie auch die übrigen Teile der einen Schmal- 4a und beider Längsseiten 3 a/b werden durch das Gehäuse 30 ausgebildet.

Im Inneren der U-förmigen Kühleinrichtung 10 sind hier drei Schaltmodule 220 der leistungselektronischen Schaltung 22 auf einer Kühlfläche 160 der Kühleinrichtung 10 angeordnet und mittels dieser mit der Kühlflüssigkeit in thermischem Kontakt. Das Kühlvolumen 16 der Kühleinrichtung 10 weist noch eine zweite Kühlfläche 162 auf, die gleichzeitig einen Teil der zweiten Hauptseite 2b ausbildet. Diese zweite Kühlfläche 162 dient beispielhaft der indirekten Kühlung einer thermisch hieran angebundenen Kondensatoreinrichtung, vgl. Fig. 6.

Die Kühlflüssigkeit des Vorlaufs 12 gelangt bei dem Leistungshalbleitermodul 1 durch einen Vorlaufzufluss 110 an der zweiten Hauptseite 2b in die Kühleinrichtung 10 und wird dort mittels eines ersten Abzweigs 122 in zwei Teilströme aufgeteilt. Der wesentliche Teil der Kühlflüssigkeit verlässt die Kühleinrichtung 10 des Leistungshalbleitermoduls 1 durch den Vorlaufabfluss 120 an der ersten Hauptseite 2a, während ein kleinerer Anteil der Kühlflüssigkeit das Kühlvolumen 16 mit angrenzender Kühlfläche 160 durchströmt.

An der ersten Hauptfläche 2a ist der Rücklaufzufluss 130 angeordnet. Die Kühlflüssigkeit des Rücklaufs 14 gelangt durch diesen in die Kühleinrichtung 10 und vereinigt sich an einem zweiten Abzweig 142 mit der Kühlflüssigkeit die das Kühlvolumen 16 durchströmt hat. Der Rücklauf 14 verlässt die Kühleinrichtung 10 danach durch den Rücklaufabfluss 140 auf der zweiten Hauptseite 2b.

Zusätzlich weist dieses Leistungshalbleitermodul 1 noch eine interne Steuerplatine 240 auf, die in fachüblicher Weise mit den Schaltmodulen 220 und mit dort angeordneten Leistungshalbleiterbauelementen schaltungsgerecht verbunden ist und Treiberfunktionalität für die leistungselektronische Schaltung 22 bereitstellt. Diese interne Steuerplatine 240 weist als Teil der leistungselektronischen Schalteinrichtung 20 an einer Schmalseite 4a des Leistungshalbleitermoduls 1 eine Steueranschlusseinrichtung 28 auf, die durch eine Ausnehmung 38 des Gehäuses 30 ragt.

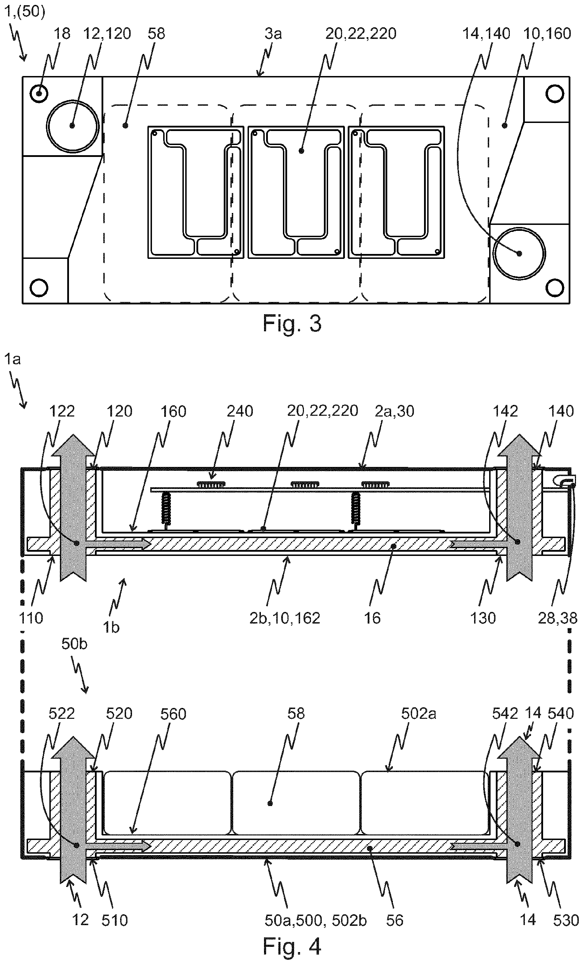

Figur 3 zeigt eine Draufsicht aus Richtung einer Hauptseite 2a auf ein Leistungshalbleitermodul 1 ohne Gehäuse bzw. gestrichelt angedeutet auf eine analog ausgebildete Kondensatoreinrichtung 50.

Dargestellt ist hier wiederum eine U-förmige Kühleinrichtung 10 mit einem Vorlaufabfluss 120 und einem Rücklaufabfluss 140 in gegenüberliegenden Ecken der ersten Hauptseite 2a. Zusätzlich sind in allen Ecken der Kühleinrichtung 10 von erster 2a zu zweiter Hauptseite 2b hindurchreichende nicht mit dem Kühlreislauf verbundene Ausnehmungen 18 vorgesehen, die der Verbindung zu weiteren Leistungshalbleitermodulen dienen, indem hierdurch Schraubverbindungen zur Verbindung der Leistungshalbleitermodule zu einer erfindungsgemäßen Anordnung anordenbar sind.

Weiterhin dargestellt ist eine Kühlfläche 160 auf der drei Schaltmodule 220 der leistungselektronischen Schaltung 22 angeordnet sind. Die von diesen Submodulen 220 zu den Längsseiten 3 a/b reichenden Lastanschlusseinrichtungen 24, 26 sind ebenso wie die von diesen Submodulen 220 zu einer Schmalseite 4 a/b reichende Hilfsanschlusseinrichtung 28 nicht dargestellt.

Die Kondensatoreinrichtung 50 mit direkter Kühlung ist bezüglich der Ausgestaltung der Kühleinrichtung identisch zum Leistungshalbleitermodul ausgebildet. Anstelle der Schaltmodule des Leistungshalbleitermoduls sind bei der Kondensatoreinrichtung drei, gestrichelt dargestellte, Kondensatoren 58 vorgesehen. Lastanschlusseinrichtungen der Kondensatoreinrichtung sind nicht dargestellt, können allerdings an der ersten Längsseite 3a vorgesehen sein.

Figur 4 zeigt im oberen Teil eine schematische Draufsicht aus Richtung einer Längsseite 3a auf einen Schnitt durch ein Leistungshalbleiterteilmodul 1b und im unteren Teil eine entsprechende Draufsicht auf eine integrierte Kondensatoreinrichtung 50b. In einer besonders vorteilhaften Ausgestaltung sind das Leistungshalbleiterteilmodul 1b und die Kondensatoreinrichtung 50b unmittelbar miteinander verbunden und bilden somit ein integriertes Leistungshalbleitermodul 1a also eines mit integrierter Kondensatoreinrichtung 50b aus. Ebenso ist es bevorzugt, wenn dieses integrierte Leistungshalbleitermodul 1a, also das

Leistungshalbleiterteilmodul 1b und die integrierte Kondensatoreinrichtung 50b von einer staub- und feuchtigkeitsdichten Verkapselung umschlossen ist, die somit ein gemeinsames Gehäuse 30 ausbildet. Da das Leistungshalbleiterteilmodul 1b und die integrierte Kondensatoreinrichtung 50b aus Gründen der Übersichtlichkeit beabstandet voneinander dargestellt sind ist die Verkapselung 30 in diesem Abstand gestrichelt dargestellt.

Das Leistungshalbleiterteilmodul 1b weist wiederum eine Kühleinrichtung 10 analog derjenigen des Leistungshalbleitermoduls gemäß Fig. 2 auf. Allerdings ist hier der Vorlaufzufluss 110, wie auch der Rücklaufzufluss 130 auf der zweiten Hauptseite 2b angeordnet. Dementsprechend sind der Vorlaufabfluss 120 und der Rücklaufabfluss 140 auf der ersten Hauptseite 2a angeordnet. Das Kühlvolumen 16 bildet hier ebenfalls nicht nur eine erste Kühlfläche 160 zur Kühlung der Schaltmodule 220 der leistungselektronischen Schalteinrichtung 20 aus, sondern auch eine zweite der ersten gegenüber liegende Kühlfläche 162. Diese zweite Kühlfläche 162 ist vorzugsweise in direktem thermischen Kontakt mit den Kondensatoren 58 der integrierten Kondensatoreinrichtung 50b.

Diese integrierte Kondensatoreinrichtung 50b weist ebenso wie das Leistungshalbleiterteilmodul 1b eine quaderförmige Grundform auf. Weiterhin weist die integrierte Kondensatoreinrichtung 50b eine eigene Kühleinrichtung 500 zur direkten Kühlung auf, die analog derjenigen des Leistungshalbleiterteilmoduls 1b einen Vorlaufzufluss 510 und einen Rücklaufzufluss 530 auf der zweiten Hauptseite 502b aufweist.

In einer weiteren bevorzugten Ausführung sind bei dem integrierten Leistungshalbleiterteilmodul 1b mit integrierter Kondensatoreinrichtung 50b die beiden Kühleinrichtungen 10, 500 des Leistungshalbleiterteilmoduls 1b und der integrierten Kondensatoreinrichtung 50b quasi einstückig ausgebildet. Hierunter soll verstanden werden, dass bei der Ausgestaltung gemäß dieses Ausführungsbeispiels ohne Beschränkung der Allgemeinheit der Vorlaufabfluss 520 der Kühleinrichtung 500 der integrierten Kondensatoreinrichtung 50b mit dem Vorlaufzufluss 110 der Kühleinrichtung 10 des Leistungshalbleiterteilmoduls 1b und der Rücklaufabfluss 540 der integrierten Kondensatoreinrichtung 50b mit dem Rücklaufzufluss 130 des Leistungshalbleiterteilmoduls 1b ohne dort vorgesehene zusätzliche Dichtmittels einstückig miteinander verbunden sind. Dies bedeutet nicht zwangsläufig, dass die jeweiligen Kühleinrichtungen10, 500 bzw. die daraus gebildete gemeinsame Kühleinrichtung intrinsisch ebenfalls einstückig ausgebildet sein müssen.

Die Kühlflüssigkeit des Vorlaufs 12 gelangt bei dem integrierten Leistungshalbleitermodul 1a durch einen Vorlaufzufluss 110 an der zweiten Hauptseite 502b in die Kühleinrichtung 10 und wird dort mittels eines zweiten Abzweigs 522 in zwei Teilströme aufgeteilt. Der wesentliche Teil der Kühlflüssigkeit fließt weiter zu einem ersten Abzweig 122 wird dort wiederum geteilt und verlässt die Kühleinrichtung 10 des integrierten Leistungshalbleiterteilmoduls 1b durch den Vorlaufabfluss 120 an der ersten Hauptseite 2a, während jeweils ein kleinerer Anteil der Kühlflüssigkeit die Kühlvolumina 16, 56 mit angrenzenden Kühlflächen 160, 162, 560 durchströmt.

Auf der Kühlfläche 560 der Kühleinrichtung 500 der integrierte Kondensatoreinrichtung 50b sind hier drei Kondensatoren 58 angeordnet und mit der zweiten Kühlfläche 162 des Leistungshalbleiterteilmoduls 1b und mit der Kühlfläche 560 der integrierten Kondensatoreinrichtung 50b in thermischem Kontakt. Somit ist es sichergestellt, dass die Kondensatoren 58 einen hervorragenden thermischen Kontakt zur Kühlflüssigkeit aufweisen. Dies ist insbesondere notwendig, da häufig die thermische Belastbarkeit der Kondensatoren 58 geringer ist als diejenige der Leistungshalbleiterbauelemente der Schaltmodule 220.

Die leistungselektronische Schalteinrichtung 20 des Leistungshalbleiterteilmoduls 1b ist grundsätzlich gleichartig derjenigen des Leistungshalbleitermoduls gemäß Fig. 2 ausgebildet und weist Schaltmodule 220, eine interne Steuerplatine 240 sowie Steuer-28, Lasteingangs- 24 und Lastausgangsanschlusseinrichtungen 26 auf. Diese Steuer-, Lasteingangs- und Lastausgangsanschlusseinrichtungen dienen der externen Verbindung des Leistungshalbleiterteilmoduls 1b. Bei der Ausgestaltung als integriertes Leistungshalbleitermodul 1a, also als Leistungshalbleiterteilmodul 1b mit integrierter Kondensatoreinrichtung 50b, ist es vorteilhaft, wenn die integrierte Kondensatoreinrichtung 50b keine externen, also von extern verbindbare, Lastanschlusseinrichtungen aufweist. Vielmehr ist es vorteilhaft, wenn die Kondensatoren 58 der integrierten Kondensatoreinrichtung 50b intern mit den zugeordneten Lastanschlusseinrichtungen 24, 26 des Leistungshalbleiterteilmoduls 1b verbunden und hierüber extern verbindbar sind. Je nach Ausgestaltung der leistungselektronischen Schaltung 22 sind die Kondensatoren 58 der integrierten Kondensatoreinrichtung 50b intern mit den Lasteingangs- 24 oder den Lastausgangsanschlusseinrichtungen 26 des Leistungshalbleiterteilmoduls 1b verbunden.

Bei dieser vorteilhaften Ausgestaltung werden die Hauptseiten des integrierten Leistungshalbleitermoduls 1a gebildet aus der ersten Hauptseite 2a des Leistungshalbleiterteilmoduls 1b und der zweiten Hauptseite 502b der integrierten Kondensatoreinrichtung 50b. Die zweite Hauptseite 2b des Leistungshalbleiterteilmoduls 1b bildet hierbei quasi nur die zweite Kühlfläche 162 des Leistungshalbleiterteilmoduls 1b aus, während die erste Hauptfläche 502a der Kondensatoreinrichtung im Wesentlichen durch die Oberfläche der zu kühlenden Kondensatoren 58 gebildet wird.

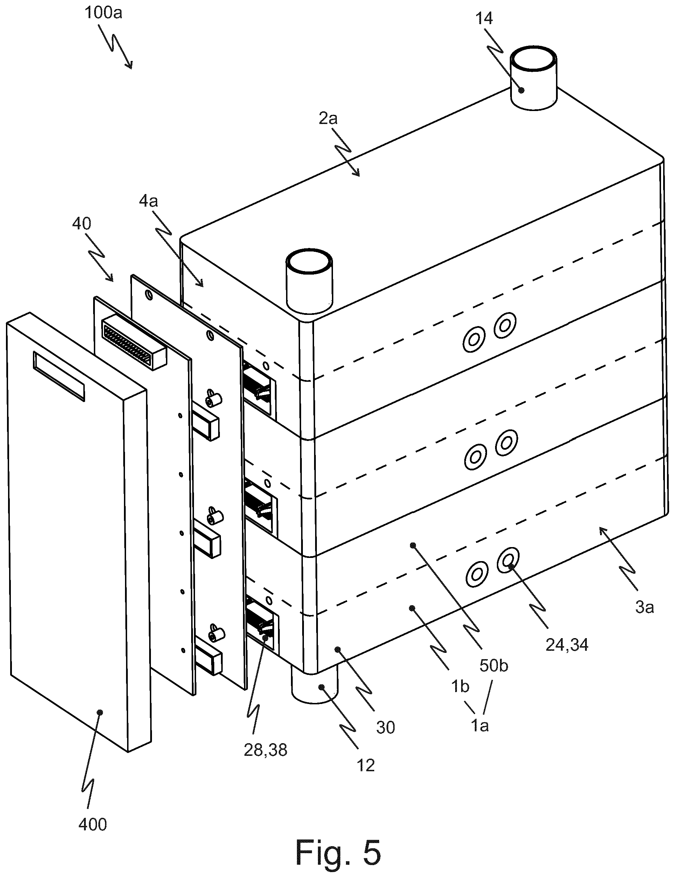

Figur 5 zeigt eine dreidimensionale Ansicht einer ersten Ausgestaltung einer Anordnung 100a zur Erläuterung der Erfindung. Dargestellt sind hier drei integrierte Leistungshalbleitermodule 1a, ihrerseits jeweils bestehend aus einem Leistungshalbleiterteilmodul 1b und einer durch eine gestrichelte, symbolische Trennlinie allerdings nicht real davon getrennten Kondensatoreinrichtung 50b, vgl. Fig. 4.

Die integrierten Leistungshalbleitermodule 1a sind unmittelbar unter Verwendung von geeigneten Dichteinrichtungen miteinander verbunden. Sie liegen somit direkt aneinander an oder weisen nur einen geringen Abstand voneinander auf. Zur Ausbildung der Anordnung 100a sind die jeweiligen integrierten Leistungshalbleitermodule 1a mittels einer nicht dargestellten Klemmeinrichtung miteinander verbunden. Ebenso können die jeweiligen Leistungshalbleitermodule 1a mittels Schraubverbindungen, vgl. Fig. 2, miteinander verbunden sein.

Die Anordnung weist jeweils einen gemeinsamen Vor- 12 und Rücklauf 14 für die Kühlflüssigkeit auf. Jedes der Leistungshalbleitermodule 1a weist auf der gleichen hier sichtbaren ersten Längsseite 3a Lasteingangsanschlusseinrichtungen 24, die hier als Gleichspannungsanschlusseinrichtungen ausgebildet sind, auf, die durch Ausnehmungen 34 des Gehäuses 30 hindurchragen. Die Wechselspannungsanschlusseinrichtungen, die Lastausgangsanschlusseinrichtungen, der mit den leistungselektronischen Schalteinrichtungen der Leistungshalbleitermodule 1a hier realisierten Wechselrichterschaltung sind auf den nicht sichtbaren zweiten Längsseiten angeordnet.

Die Hilfsanschlusseinrichtung 28 aller Leistungshalbleitermodule 1a der Anordnung 100a sind auf einer Schmalseite 4a der jeweiligen Leistungshalbleitermodule 1a angeordnet. Dies hat den entscheidenden Vorteil, dass die Längsseiten 3 a/b für die Ausbildung der externen Lastverbindungen frei verfügbar sind. Somit ist eine besonders vorteilhafte, beispielsweise niederinduktive externe Verbindung mit dieser Anordnung 100a realisierbar.

Die Hilfsanschlusseinrichtungen 28 ragen durch zugeordnete Ausnehmungen 38 des Gehäuses 30 und sind hier mit einer gemeinsamen externen Steuerplatine 40 verbunden, die verschiedene Funktionalität aufweisen kann. Sie kann nur der Signalverbindung dienen aber auch komplexe Steuer- und Überwachungsfunktionalität aufweisen. In der hier gezeigten Ausfertigung weist die externe Steuerplatine 40 noch eine Dichteinrichtung 400 auf um gegen Umwelteinflüsse geschützt zu sein. Dies ist insbesondere in Kombination mit staub- und feuchtigkeitsdicht verkapselten integrierten Leistungshalbleitermodulen 1a vorteilhaft.

Figur 6 zeigt eine dreidimensionale Ansicht einer zweiten, erfindungsgemäßen Ausgestaltung der Anordnung 100. Hierbei sind eine Mehrzahl von Leistungshalbleitermodulen 1 vergleichbar denjenigen gemäß Fig. 2 alternierend mit Kondensatoreinrichtungen 50 angeordnet. Zur Ausbildung des Vor- 12 und Rücklaufs 14 der Kühlflüssigkeit in der Anordnung 100 sind die Leistungshalbleitermodule 1 mittelbar oder unmittelbar miteinander verbunden, indem der Vorlaufabfluss 120 eines Leistungshalbleitermoduls mit dem Vorlaufzufluss 110 des benachbarten Leistungshalbleitermoduls und in ebensolcher Weise der Rücklaufabfluss 140 des Leistungshalbleitermoduls mit dem Rücklaufzufluss 130 des benachbarten Leistungshalbleitermoduls verbunden ist.

Diese Verbindung kann unmittelbar oder mittelbar, also unter Zwischenschaltung von Verbindungsstücken, ausgebildet sein. Jeweils sind selbstverständlich geeignete Dichteinrichtungen in beiden Varianten fachüblich vorzusehen.

Die jeweiligen Kondensatoreinrichtungen 50 weisen keine eigenen Kühleinrichtungen auf und sind somit über Kühlflächen 162 der Leistungshalbleitermodule 1 ausschließlich indirekt gekühlt.

Ebenso sind hier Lastanschlusseinrichtungen 524 der Kondensatoreinrichtung 50 in Normalenrichtung der Hauptflächen 2 a/b fluchtend zu zugeordneten Lasteingangsanschlusseinrichtungen 24 der Leistungshalbleitermodule 1 dargestellt. Diese ermöglicht eine besonders einfache Verbindung von externen Anschlusseinrichtungen gleicher Polarität. An den zweiten nicht sichtbaren Längsseiten sind die Lastausgangsanschlusseinrichtungen der Leistungshalbleitermodule 1 angeordnet. Hilfsanschlusseinrichtungen sind hier nicht dargestellt aber selbstverständlich an den Schmalseiten der Leistungshalbleitermodule vorsehbar.

## Patentansprüche

1. Anordnung (100) mit einem Kühlkreislauf, einer Mehrzahl von anreihbaren Leistungshalbleitermodulen (1) und mindestens einer Kondensatoreinrichtung (50), wobei ein Leistungshalbleitermodul (1) eine leistungselektronische Schalteinrichtung (20) und eine durchströmbare Kühleinrichtung (10) zur Kühlung der Schalteinrichtung (20) aufweist, die ein Kühlvolumen (16) mindestens eine Kühlfläche (160, 162) und vier Anschlusseinrichtungen (110, 120, 130, 140) für eine Kühlflüssigkeit aufweist, wobei die Anschlusseinrichtungen (110, 120, 130, 140) paarweise an Hauptseiten (2 a/b) des Leistungshalbleitermoduls (1) angeordnet sind,
und wobei die Leistungshalbleitermodule (1) mit ihren Hauptseiten (2 a/b) aneinandergereiht sind, indem korrespondierende Anschlusseinrichtungen (110, 120, 130, 140) aufeinanderfolgender Leistungshalbleitermodule (1) mittelbar oder unmittelbar miteinander verbunden sind und wobei
zwischen mindestens zwei aufeinanderfolgenden Leistungshalbleitermodulen (1) eine Kondensatoreinrichtung (50) angeordnet ist, die ihrerseits mittels des Kühlkreislaufes der Anordnung direkt oder indirekt gekühlt wird, wobei jedes anreihbare Leistungshalbleitermodul (1), mit einer quaderförmigen, jeweils zwei sich paarweise gegenüberliegenden Haupt- (2a, 2b), Längs- (3a, 3b) und Schmalseiten (4a, 4b) aufweisenden Grundform, mit einer durchströmbaren U-förmig ausgebildeten Kühleinrichtung (10), einer leistungselektronischen Schalteinrichtung (20), die in der Ausnehmung der der U-förmig ausgebildeten Kühleinrichtung (10) angeordnet ist, und einem Gehäuse (30) zur Überdeckung der leistungselektronischen Schalteinrichtung (20).

2. Anordnung nach Anspruch 1, wobei
das Leistungshalbleitermodul (1) eine leistungselektronische Schalteinrichtung (20) mit einer leistungselektronischen Schaltung (22), Steuer- (28), Lasteingangs- (24) und Lastausgangsanschlusseinrichtungen (26) und vorzugsweise ein Gehäuse (30) mit Ausnehmungen (34, 36, 38) für diese Anschlusseinrichtungen (110, 120, 130, 140) aufweist, und hierbei das Gehäuse (30) die leistungselektronische Schaltung (22) zur die Kühleinrichtung (10) hin überdeckt.

3. Anordnung nach Anspruch 2, wobei
die Kondensatoreinrichtung (50) Lastanschlusseinrichtungen (524) aufweist und diese schaltungsgerecht mit zugeordneten Lasteingangs- (24) oder Lastausgangsanschlusseinrichtungen (26) mindestens eines Leistungshalbleitermoduls (1) verbunden sind.

4. Anordnung nach einem der vorhergehenden Ansprüche, wobei
die Anschlusseinrichtungen (110, 120, 130, 140) für Kühlflüssigkeit des jeweiligen Leistungshalbleitermoduls (1) jeweils als ein Vorlaufzufluss (110) und ein Vorlaufabfluss (120) sowie als ein Rücklaufzufluss (130) und ein Rücklaufabfluss (140) ausgebildet sind.

5. Anordnung nach Anspruch 4, wobei
bei den jeweiligen Leistungshalbleitermodulen (1) der Vorlaufzufluss (110) und der Rücklaufabfluss (140), sowie der Vorlaufabfluss (120) und der Rücklaufzufluss (130) jeweils auf einer Hauptseite (2 a/b) oder wobei
der Vorlaufzufluss (110) und der Rücklaufzufluss (130), sowie der Vorlaufabfluss (120) und der Rücklaufabfluss (140) jeweils auf einer Hauptseite (2 a/b) angeordnet sind.

6. Anordnung nach Anspruch 5, wobei
der Vorlaufabfluss (120) eines Leistungshalbleitermoduls (1) mit dem Vorlaufzufluss (110) und der Rücklaufzufluss (130) mit dem Rücklaufabfluss (140) des nachfolgenden Leistungshalbleitermoduls (1) mittelbar oder unmittelbar verbunden sind oder
wobei die Leistungshalbleitermodule (1) aneinandergereiht sind, indem der Vorlaufabfluss (120) eines Leistungshalbleitermoduls mit dem Vorlaufzufluss (110) und der Rücklaufabfluss (140) mit dem Rücklaufzufluss (130) des nachfolgenden Leistungshalbleitermoduls mittelbar oder unmittelbar verbunden sind.

7. Anordnung nach Anspruch 4, wobei
das Leistungshalbleitermodul (1) zwischen dem Vorlaufzufluss (110) und dem Vorlaufabfluss (120) ein erster Abzweig (122) sowie zwischen Rücklaufzufluss (130) und Rücklaufabfluss (140) ein zweiter Abzweig (142) angeordnet sind, wodurch das Kühlvolumen (16) der Kühleinrichtung (10) mit Kühlflüssigkeit von einem Vorlauf (12) zu einem Rücklauf (14) durchströmbar ist.

8. Anordnung nach Anspruch 1, wobei
die Kondensatoreinrichtung (50) in thermisch leitendem Kontakt mit einer Kühlfläche (160, 162) eines oder beider benachbarter Leistungshalbleitermodule (1) steht und die korrespondierenden Anschlusseinrichtungen (110, 120, 130, 140) benachbarter Leistungshalbleitermodule unmittelbar miteinander verbunden sind.

9. Anordnung nach Anspruch 1, wobei
die Kondensatoreinrichtung (50) eigene zweite Anschlusseinrichtungen (510, 520, 530, 540) aufweist, die jeweils als ein Vorlaufzufluss (510) und ein Vorlaufabfluss (520) sowie als eine Rücklaufzufluss (530) und ein Rücklaufabfluss (540) ausgebildet sind und die korrespondierenden Anschlusseinrichtungen (110, 120, 130, 140) benachbarter Leistungshalbleitermodule mittelbar miteinander verbunden sind indem die Kondensatoreinrichtung (50) in Bezug auf den Kühlkreislauf dazwischengeschaltet ist.

10. Anordnung nach Anspruch 1, wobei
die Kondensatoreinrichtung (50) durchströmbar für die Kühlflüssigkeit ausgebildet ist und somit ein zweites Kühlvolumen (56) sowie zu dessen Durchströmung zwei dem Vor- (12) bzw. Rücklauf (14) zugeordnete Abzweige (522, 542) aufweist.

## Claims

1. Assembly (100) comprising a cooling circuit, a plurality of in-line power semiconductor modules (1) and at least one capacitor device (50), wherein a power semiconductor module (1) has a power-electronics switching device (20) and a cooling device (10), which is capable of carrying a flow, for cooling the switching device (20), the said cooling device having a cooling volume (16), at least one cooling face (160, 162) and four connection devices (110, 120, 130, 140) for a cooling liquid, wherein the connection devices (110, 120, 130, 140) are arranged in pairs on main sides (2a/b) of the power semiconductor module (1), and wherein the power semiconductor modules (1) have their main sides (2a/b) lined up by virtue of corresponding connection devices (110, 120, 130, 140) of successive power semiconductor modules (1) being indirectly or directly connected to one another, and wherein a capacitor device (50) is arranged between at least two successive power semiconductor modules (1) and, for its part, is directly or indirectly cooled by means of the cooling circuit of the assembly, wherein each in-line semiconductor module (1), having a cuboidal basic shape which has in each case two main sides (2a, 2b), longitudinal sides (3a, 3b) and narrow sides (4a, 4b) situated opposite one another in pairs, with a cooling device (10) which is capable of carrying a flow and is of U-shaped design, a power-electronics switching device (20) which is arranged in the recess of the cooling device (10) which is of U-shaped design, and a housing (30) for covering the power-electronics switching device (20).

2. Assembly according to Claim 1, wherein the power semiconductor module (1) has a power-electronics switching device (20) having a power-electronics circuit (22), control connection devices (28), load input connection devices (24) and load output connection devices (26) and preferably a housing (30) having recesses (34, 36, 38) for these connection devices (110, 120, 130, 140), and in this case the housing (30) covers the power-electronics circuit (22) in the direction of the cooling device (10).

3. Assembly according to Claim 2, wherein the capacitor device (50) has load connection devices (524) and these are connected by means of compliant circuitry to associated load input connection devices (24) or load output connection devices (26) of at least one power semiconductor module (1).

4. Assembly according to one of the preceding claims, wherein the connection devices (110, 120, 130, 140) for cooling liquid of the respective power semiconductor module (1) are respectively in the form of a feed inflow (110) and a feed outflow (120) and also of a return inflow (130) and a return outflow (140).

5. Assembly according to Claim 4, wherein, in the respective power semiconductor modules (1), the feed inflow (110) and the return outflow (140), and the feed outflow (120) and the return inflow (130), are respectively arranged on one main side (2a/b), or wherein the feed inflow (110) and the return inflow (130), and the feed outflow (120) and the return outflow (140), are respectively arranged on one main side (2a/b).

6. Assembly according to Claim 5, wherein the feed outflow (120) of one power semiconductor module (1) is indirectly or directly connected to the feed inflow (110), and the return inflow (130) is indirectly or directly connected to the return outflow (140), of the downstream power semiconductor module (1), or wherein the power semiconductor modules (1) are lined up by virtue of the feed outflow (120) of one power semiconductor module being indirectly or directly connected to the feed inflow (110), and the return outflow (140) being indirectly or directly connected to the return inflow (130), of the downstream power semiconductor module.

7. Assembly according to Claim 4, wherein the power semiconductor module (1) a first branch (122) is arranged between the feed inflow (110) and the feed outflow (120), and a second branch (142) is arranged between the return inflow (130) and the return outflow (140), as a result of which the cooling volume (16) of the cooling device (10) is capable of carrying a flow of cooling liquid from a feed (12) to a return (14).

8. Assembly according to Claim 1, wherein the capacitor device (50) is in thermally conductive contact with a cooling face (160, 162) of one or both adjacent power semiconductor modules (1), and the corresponding connection devices (110, 120, 130, 140) of adjacent power semiconductor modules are directly connected to one another.

9. Assembly according to Claim 1, wherein the capacitor device (50) has dedicated second connection devices (510, 520, 530, 540) which are respectively in the form of a feed inflow (510) and a feed outflow (520), and in the form of a return inflow (530) and a return outflow (540), and the corresponding connection devices (110, 120, 130, 140) of adjacent power semiconductor modules are indirectly connected to one another by virtue of the capacitor device (50) being intermediately connected with respect to the cooling circuit.

10. Assembly according to Claim 1, wherein the capacitor device (50) is designed to be capable of carrying a flow of the cooling liquid and therefore has a second cooling volume (56) and, for flow through the latter, two branches (522, 542) which are associated with the feed (12) and, respectively, the return (14).

## Revendications

1. Agencement (100), pourvu d'un circuit de refroidissement, d'une pluralité de modules semi-conducteurs de puissance (1) juxtaposables et d'au moins un dispositif de condensateur (50), un module semi-conducteur de puissance (1) comportant un dispositif de commutation (20) électronique de puissance et un dispositif de refroidissement (10) irrigable, destiné à refroidir le dispositif de commutation (20), qui comporte un volume de refroidissement (16), au moins une surface de refroidissement (160, 162) et quatre dispositifs de raccordement (110, 120, 130, 140) pour un liquide réfrigérant, les dispositifs de raccordement (110, 120, 130, 140) étant placés par paires sur les côtés principaux (2 a/b) du module semi-conducteur de puissance (1), et les modules semi-conducteurs de puissance (1) étant juxtaposés par leurs côtés principaux (2 a/b), en ce que des dispositifs de raccordement (110, 120, 130, 140) correspondants de modules semi-conducteurs de puissance (1) successifs sont reliés indirectement ou directement les uns avec les autres et entre au moins deux modules semi-conducteurs de puissance (1) successifs étant placé un dispositif de condensateur (50) qui pour sa part est refroidi directement ou indirectement au moyen du circuit de refroidissement de l'agencement, chaque module semi-conducteur de puissance (1) juxtaposable avec une forme de base quadratique, comportant respectivement deux côtés principaux (2a, 2b), longitudinaux (3a, 3b) et étroits (4a, 4b) mutuellement opposés par paire, avec un dispositif de refroidissement (10) irrigable conçu en forme de U, un dispositif de commutation (20) électronique de puissance, qui est placé dans l'évidement du dispositif de refroidissement (10) conçu en forme de U, et un boîtier (30), destiné à recouvrir le dispositif de commutation (20) électronique de puissance.

2. Agencement selon la revendication 1, le module semi-conducteur de puissance (1) comportant un dispositif de commutation (20) électronique de puissance, pourvu d'un circuit électronique de puissance (22), de dispositifs de commande (28), de raccordement d'entrée de charge (24) et de raccordement de sortie de charge (26) et de préférence d'un boîtier (30) pourvu d'évidements (34, 36, 38) pour lesdits dispositifs de raccordement (110, 120, 130, 140), et à cet effet, le boîtier (30) recouvrant le circuit électronique de puissance (22) en direction du dispositif de refroidissement (10).

3. Agencement selon la revendication 2, le dispositif de condensateur (50) comportant des dispositifs de raccordement de charge (524) et ces derniers étant reliés conformément au circuit avec des dispositifs de raccordement d'entrée de charge (24) ou de raccordement de sortie de charge (26) d'au moins un module semi-conducteur de puissance (1).

4. Agencement selon l'une quelconque des revendications précédentes, les dispositifs de raccordement (110, 120, 130, 140) étant conçus chacun sous la forme d'une alimentation aller (110) et d'une évacuation aller (120), ainsi que d'une alimentation retour (130) et d'une évacuation retour (140) pour le liquide réfrigérant du module semi-conducteur de puissance (1) respectif.

5. Agencement selon la revendication 4, dans le cas des modules semi-conducteurs de puissance (1) respectifs, l'alimentation aller (110) et l'évacuation retour (140), ainsi que l'évacuation aller (120) et l'alimentation retour (130) étant placées respectivement sur un côté principal (2 a/b) ou l'alimentation aller (110) et l'alimentation retour (130), ainsi que l'évacuation aller (120) et l'évacuation retour (140) étant placées respectivement sur un côté principal (2 a/b).

6. Agencement selon la revendication 5, l'évacuation aller (120) d'un module semi-conducteur de puissance (1) étant reliée indirectement ou directement avec l'alimentation aller (110) et l'alimentation retour (130) étant reliée indirectement ou directement avec l'évacuation retour (140) du module semi-conducteur de puissance (1) suivant ou les modules semi-conducteurs de puissance (1) étant juxtaposés en ce que l'évacuation aller (120) d'un module semi-conducteur de puissance est reliée indirectement ou directement avec l'alimentation aller (110) et l'évacuation retour (140) est reliée indirectement ou directement avec l'alimentation retour (130) du module semi-conducteur de puissance suivant.

7. Agencement selon la revendication 4, le module semi-conducteur de puissance (1) entre l'alimentation aller (110) et l'évacuation aller (120) étant placé un premier embranchement (122), ainsi qu'entre l'alimentation retour (130) et l'évacuation retour (140) étant placé un deuxième embranchement (142), suite à quoi le volume de refroidissement (16) du dispositif de refroidissement (10) est irrigable par du liquide réfrigérant d'un aller (12) vers un retour (14).

8. Agencement selon la revendication 1, le dispositif de condensateur (50) étant en contact conducteur thermique avec une surface de refroidissement (160, 162) d'un ou des deux modules semi-conducteurs de puissance (1) adjacents et les dispositifs de raccordement (110, 120, 130, 140) correspondants de modules semi-conducteurs de puissance adjacents étant reliés directement les uns aux autres.

9. Agencement selon la revendication 1, le dispositif de condensateur (50) comportant des propres deuxièmes dispositifs de raccordement (510, 520, 530, 540) qui sont conçus respectivement comme une alimentation aller (510) et une évacuation aller (520), ainsi que comme une alimentation retour (530) et une évacuation retour (540) et les dispositifs de raccordement (110, 120, 130, 140) correspondants de modules semi-conducteurs de puissance adjacents étant reliés indirectement les uns aux autres en ce que le dispositif de condensateur (50) est intercalé en rapport au circuit de refroidissement.

10. Agencement selon la revendication 1, le dispositif de condensateur (50) étant conçu en étant irrigable de manière pous le liquide réfrigérant et comportant ainsi un deuxième volume de refroidissement (56), ainsi que pour l'irrigation de celui-ci, deux embranchements (522, 542) associés à l'aller (12) ou au retour (14).
